(19) Europäisches Patentamt

European Patent Office

Office européen des brevets

(11) Veröffentlichungsnummer: **0 468 420 A2**

(12) **EUROPÄISCHE PATENTANMELDUNG**

(21) Anmeldenummer: **91112267.9**

(22) Anmeldetag: **22.07.91**

(51) Int. Cl.⁵: **H01L 23/495**

(30) Priorität: **23.07.90 DE 9010920 U**

(43) Veröffentlichungstag der Anmeldung:
**29.01.92 Patentblatt 92/05**

(84) Benannte Vertragsstaaten:
**AT BE CH DE FR GB IT LI NL**

(71) Anmelder: **Siemens Nixdorf
Informationssysteme Aktiengesellschaft
Fürstenallee 7**
**W-4790 Paderborn(DE)**

(72) Erfinder: **Ernstberger, Johann, Dipl.-Ing.
Sexauerstrasse 10
W-8000 München 82(DE)**

(74) Vertreter: **Fuchs, Franz-Josef, Dr.-Ing. et al
Postfach 22 13 17
W-8000 München 22(DE)**

(54) **Integrierter Baustein in Flachpackbauweise.**

㊡ Die Erfindung bezieht sich auf einen integrierten Baustein in in Flachpack(Flat Packages)-Bauweise mit seitlich herausragenden Anschlußleitungen (Leads). Bei der Herstellung dieser Anschlußleitungen muß besondere Sorgfalt, insbesondere was den Stanzgrad und ähnliches anbetrifft angewendet werden. Um die sich daraus ergebenden Nachteile zu vermeiden, sieht die Erfindung vor, daß die Anschlußleitungen an ihren Enden eingerollt sind.

EP 0 468 420 A2

Die Erfindung betrifft einen integrierten Baustein in Flach-Pack (Flat Packages) Bauweise mit seitlich herausragenden Anschlußleitungen (Leads).

Bei integrierten Bausteinen in Flachpackbauweise (Flat Pack's) handelt es sich um sehr flach aufgebaute integrierte Schaltungen, bei denen auf einem meist Keramikträgermaterial neben dem eigentlichen Chip die Leiterbahnen im Druckverfahren aufgebracht sind. Für den Anschluß nach außen sind Anschlußleitungen, sogenannte Leads, vorgesehen, die meist geradlinig oder leicht abgeknickt aus dem Keramikkörper herausragen.

Diese Leitungen müssen sehr sorgfältig ausgebildet sein um einen guten Kontakt zwischen dem Chip und der ihn aufnehmenden Träger, wie z.B. eine Leiterplatte, zu gewährleisten. Vor allem führen die vorgegebenen Toleranzforderungen zur Ausbildung kleiner Biegeradien und damit zu einer hohen Bruchgefahr der abgegebenen Stellen der Anschlußleitungen.

Aufgabe der vorliegenden Erfindung ist es, einen integrierten Baustein in Flachpackbauweise zu schaffen, bei der die Nachteile bei der Herstellung der Anschlußleitungen derartiger Flat Pack's vermieden werden.

Zur Lösung dieser Aufgabe sieht die Erfindung vor, daß die Anschlußleitungen an ihren Enden eingerollt sind.

Durch diese Maßnahmen erhält man den Vorteil, daß der Stanzgrad beliebig sein kann. Die Biegeradien können günstig gewählt werden, so daß sich Risse bis ins Grundmaterial bei engen Radien vermeiden lassen. Bei Unebenheiten ist durch diese Ausbildung auch ein Spannungsausgleich in vertikaler Richtung gewährleistet. Gleichzeitig erhält man dadurch günstigere Einbauplatzverhältnisse. Durch die Ausbildung zweier Lotkehlen an den abgerundeten Stellen der Anschlußleitungen wird auch die Qualität der Lötverbindung erhöht.

Anhand des Ausführungsbeispiels wird die Erfindung näher erläutert.

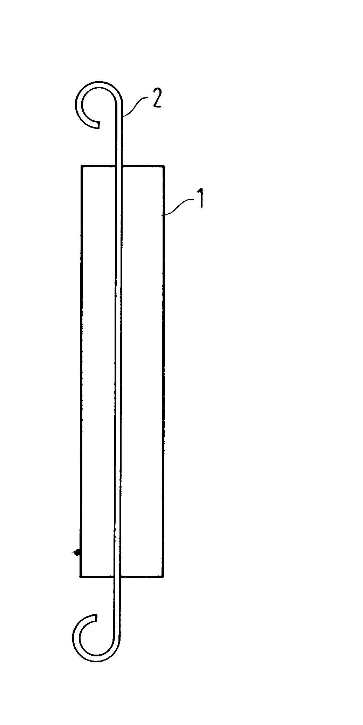

Die Figur zeigt in Seitenansicht den Flat-Pack-Keramikkörper 1 und eine dazugehörige Anschlußleitung 2, die auf beiden Seiten aus dem Keramikkörper 1 herausragt. Die Enden der Anschlußleitung 2 sind nach innen eingerollt und zwar so, daß zwischen dem Deckel des Flat Pack's und der Auflagefläche des eingerollten Teils der Anschlußleitung 2 ein vorgegebener Abstand eingehalten wird. Die Verbindung zwischen der Anschlußleitung 2 und dem für den Flat Pack vorgesehenen Träger, wie z.B. einer Leiterplatte, erfolgt im unteren äußersten Bereich des eingerollten Teils der Anschlußleitung. Durch die gebogene Form der Enden der Anschlußleitungen entsteht eine Federwirkung, durch die Unebenheiten in der Auflagefläche ausgeglichen werden können.

**Patentansprüche**

1. Integrierter Baustein in Flach-Pack (Flat-Packages)-Bauweise mit seitlich herausragenden Anschlußleitungen (Leads), **dadurch gekennzeichnet,** daß die Anschlußleitungen an ihren Enden eingerollt sind.